# EUROPEAN PATENT APPLICATION

(11) **EP 1 811 772 A2**
(43) Date of publication of application: **25.07.2007**
(21) Application number: 07000825.5
(22) Date of filing: 16.01.2007
(51) Int. Cl.: H04N 5/335

(54) **Image sensor module having precise image-projection control**

(30) Priority: 24.01.2006 CN 200610001696
(71) Applicant: Visera Technologies Company Ltd., VI Science Park Hsin-Chu City 300 (CN)
(72) Inventor: Lee, Hsiao-Wen, Hsinchu City 300 (TW); Zung, Pai-Chun Peter, Hsinchu (TW); Lin, Tzu-Han, Hsinchu City 300 (TW); Lin, Chien-Pang, Zhubei City Hsinchu County 302 (TW)
(74) Representative: Becker Kurig Straus

(57) **Abstract**

An image sensor module (3) comprises an image sensor chip (30), at least one lens layer (32), and at least one bonding layer (31). The image sensor chip (30) has an image capturing zone (301) manufactured with an image capturing element (300), and a partition zone (302) surrounding the image capturing zone (301). The at least one lens layer (32) is stacked on the image sensor chip (30), having a transparent substrate (320) and a lens (321) mounted on the transparent substrate (320) and adapted to focus the projected image onto the image capturing zone (301) of the image sensor chip (30). The at least one bonding layer (31) is arranged corresponding to the partition zone (302) of the image sensor chip (30) and bonded between the image sensor chip (30) and the at least one lens layer (32), mixing of a glue agent (311) and a plurality of spacer elements (310) with which the height of each the spacer elements (310) is determined to be the height of the bonding layer (31).

## Description

### BACKGROUND OF THE INVENTION

### 1. Field of the Invention

The present invention relates to image sensor modules and more particularly, to an image sensor module having precise image-projection control.

### 2. Description of the Related Art

An image sensor module applicable to a camera device used in a cell phone, PDA, or any of a variety of portable electronic products is generally comprised of an image sensor chip, which is made through an image-sensor technology of the semiconductor manufacturing, and an optical lens assembly. When the optical lens assembly projects an object onto the image sensor chip, the circuit operation of the image sensor chip accurately picks up the projected image and passes the image signal of the object to the aforementioned portable electronic product. The quality of the image projection of the optical lens assembly determines the quality of the image signal processed by the image sensor chip. If the optical lens assembly manufactured by a module engineering of stacking and joining lenses together cannot focus a projected image onto the image sensor chip precisely, an out-of-focus problem will occur, thereby degrading the image quality.

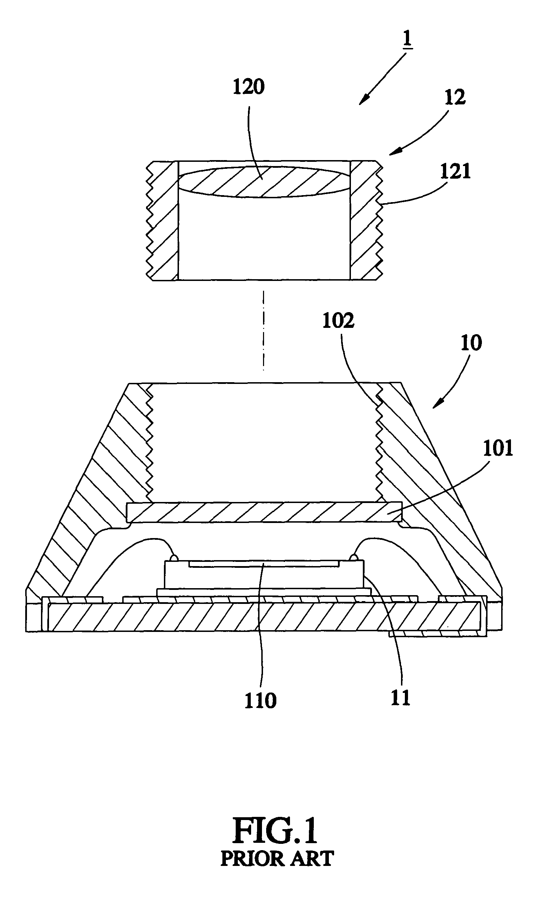

FIG 1 is an exploded view of a focus adjustable type image sensor module according to the prior art. According to this design, the image sensor module **1** comprises a screw body **10,** a sensor chip **11,** and a lens assembly **12.** The image sensor chip **11** is fixedly mounted inside the body **10,** having an image pick-up element **110** on the position aligned with the direction of a main optical axis. The body **10** has a transparent substrate **101** and a threaded inside wall **102.** The transparent substrate **101** and the threaded inside wall **102** define an accommodation chamber for accommodating the lens assembly **12.** The lens assembly **12** has an optical lens **120,** and a threaded outside wall **121** threaded into the threaded inside wall **102** of the body **10.** By means of adjusting the depth of the lens assembly **12** inside the accommodation chamber with rotating along the threading path of the threaded inside wall **102** of the body **10,** optical aberrations caused by the lens **120** module engineering of the formation of the lens assembly **12** are controlled, so that the lens **120** accurately focuses the image onto the image pick-up element **110.** However, the friction force that is produced during rotation of the lens assembly **12** may cause fine particles to fall from the interface between the threaded inside wall **102** of the body **10** and the threaded outside wall **121** of the lens assembly **12** to the transparent plate **101.** As a result, impurities may block the optical path to lower the quality of the image projection of an object. Further, the threaded inside wall **102** of the body **10** must have a certain height so that the lens assembly **12** can be adjusted vertically therein. Thus, the image sensor module **1** cannot fit the requirement for a small-sized portable electronic product.

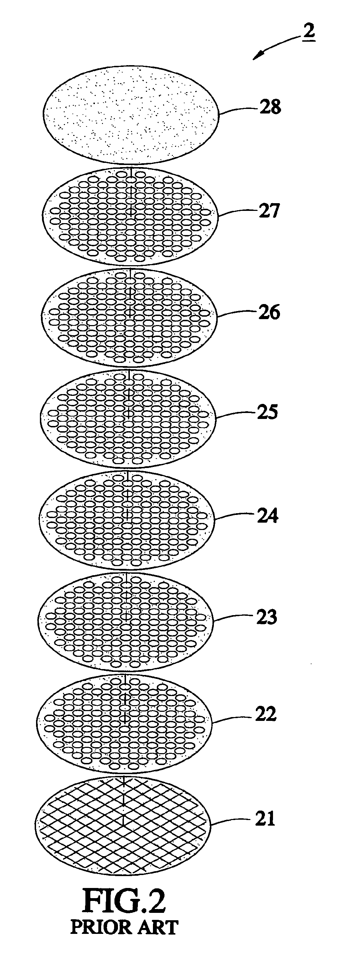

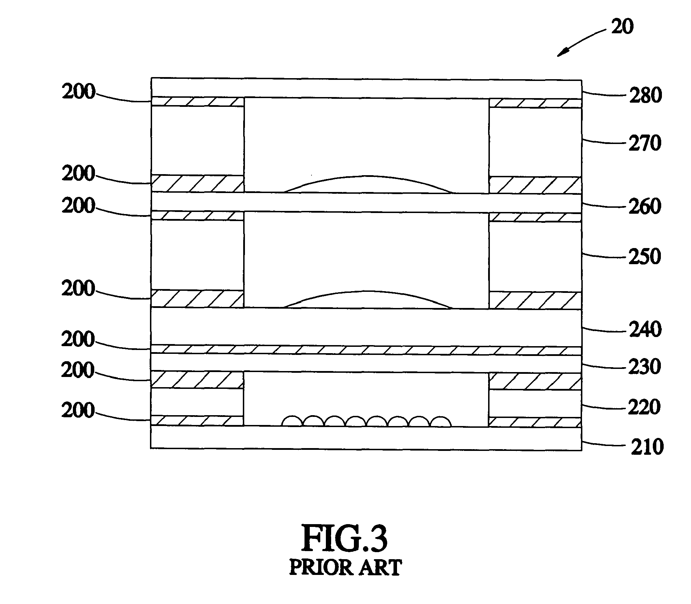

FIG 2 shows a stacking type of image sensor module made by semiconductor wafer manufacturing according to the prior art. According to this design, the image sensor module **2** comprises a silicon wafer **21,** a first spacer plate **22,** a first cover plate **23,** a first lens module **24,** a second spacer plate **25,** a second lens module **26,** a third spacer plate **27,** and a second cover plate **28,** which are stacked in sequence. The spacer plates **22, 25** and **27** are made of transparent glass with grinding and polishing to a predetermined thickness, and respectively provided with openings for passing image forming light rays from the lens modules **24** and **26,** to the silicon wafer **21.** The stacked structure of the image sensor module **2** is than cut into multiple image sensor elements **20.** As shown in FIG 3, each image sensor elements **20** comprises an image sensor chip **210,** a first spacer **220,** a first cover **230,** a first lens **240,** a second spacer **250,** a second lens **260,** a third spacer **270,** and a second cover **280.** Also a sticky resin material is provided then hard-baked between each two adjacent layers of the image sensor module **2** thus forming multiple adhesive layers **200** of the image sensor element **20.** Therefore, the optical distance of the image forming light rays from the lenses **240** and **260** to the projected image on the image sensor chip **210** is controlled by the thickness of the spacers **220** and **250** and the adhesive layers **200.** Practically, there is about 5% error in the grinding process of forming the spacers **220, 250** and **270,** and more than 20% error in the film thickness control of the resin material for the adhesive layers **200.** Under the factor of multi-layer manufacturing errors, it is difficult to accurately focus the projected image by the lenses **240** and **260** onto the image sensor chip **210,** thereby degrading the image forming quality of the image sensor element **20.**

### SUMMARY OF THE INVENTION

The present invention has been accomplished under the circumstances in view. It is therefore the main object of the present invention to provide an image sensor module having precise image-projection control, which uses a wafer level structure to effectively control the lens module dimensions suitable for use in small-sized portable electronic product.

It is another object of the present invention to provide an image sensor module having precise image-projection control, which effectively eliminates optical error caused by module engineering, thereby obtaining optimal image quality

To achieve these and other objects of the present invention, the image sensor module comprises an image sensor chip, at least one lens layer, and at least one bonding layer. The image sensor chip has an image capturing zone manufactured with an image capturing element, and a partition zone surrounding the image capturing zone. The at least one lens layer is stacked on the image sensor chip, having a transparent substrate and a lens mounted on the transparent substrate and adapted to focus the projected image onto the image capturing zone of the image sensor chip. The at least one bonding layer is arranged corresponding to the partition zone of the image sensor chip, mixing of a glue agent and a plurality of spacer elements. The height of the spacer elements is determined to be the height of the bonding layer. The at least one bonding layer is bonded between the image sensor chip and the at least one lens layer.

### BRIEF DESCRIPTION OF THE DRAWINGS

FIG 1 is an exploded view of a screw joint focus adjustment type image sensor module according to the prior art.
FIG 2 is an exploded view of a stacked design of image sensor module structure made by semiconductor wafer manufacturing technology according to the prior art.
FIG 3 is a schematic sectional view of one module element cut from the stacked design of image sensor module structure made shown in FIG 2.
FIG 4 is a schematic sectional view of an image sensor module in accordance with a first embodiment of the present invention.
FIG 5 is a schematic sectional view of an image sensor module in accordance with a second embodiment of the present invention.

### DETAILED DESCRIPTION OF THE INVENTION

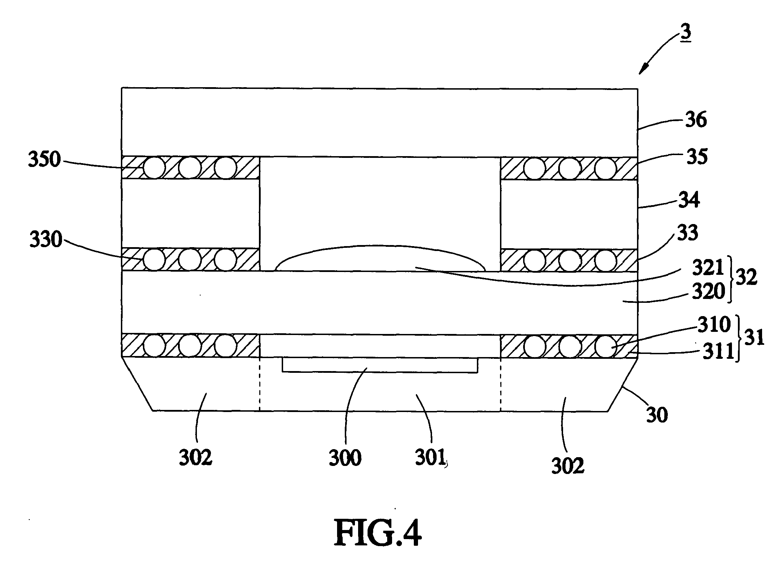

Referring to FIG 4, an image sensor module **3** in accordance with a first embodiment of the present invention is a device element of a stacked structure cut from a wafer level module, comprising an image sensor chip **30,** a lens layer **32,** a spacer layer **34** and a cover layer **36** that are stacked on one another in proper order, and bonding layers **31, 33** and **35** that are respectively bonded between each two adjacent layers of the stacked structure of the image sensor chip **30,** lens **32,** spacer layer **34** and cover layer **36.**

The image sensor chip **30** is a CIS technology manufactured integrated chip, i.e., CMOS (Complementary Metal Oxide Semiconductor) image sensor chip, defining an image capturing zone **301** and a partition zone **302.** The image capturing zone **301** is surrounded by the partition zone **302** and having an image capturing element **300** manufactured thereon.

The lens layer **32** comprises a transparent substrate **320** and a lens **321** mounted on the transparent base **320.** The transparent substrate **320** is pervious to light to maintain the image forming quality. The lens **321** is adapted to focus the image on the image capturing element **300.**

The spacer layer **34** is set corresponding to the partition zone **302** of the image sensor chip **30.** Same as the prior art designs, the spacer layer **34** is made of a glass material with grinding and polishing subject to the desired thickness.

The cover layer **36** is on the top of the image sensor module **3.** It is a transparent member that pervious to light, and protects the lens layer **32** against environmental pollution to maintain the quality of the image sensor module **3.**

The bonding layers **31, 33** and **35** are arranged corresponding to the partition zone **302** of the image sensor chip **30** for bonding each two adjacent layers mentioned right above respectively, i.e., the image sensor chip **30,** the lens layer **32,** the spacer layer **34,** and the cover layer **36** in sequence. The first bonding layer **31** is formed of a glue agent **311** and a plurality of spacer elements **310** for adhering the lens layer **32** to the image sensor chip **30.** Preferably, the spacer elements **310** are spherical glass beads made of hot melt silicon dioxide with the manufacturing error of the bead diameter being controlled within about 1%; and the volume density of mixing the spacer elements **310** and the glue agent **311** is at the respective ratio of about 1:50. The second bonding layer **33** and the third bonding layer **35** have the same material composition as the first bonding layer **31,** each having multiple spacer elements **330** or **350** that have a respective specific size and arranged subject to a respective specific mixing density The second bonding layer **33** is bonded between the lens layer **32** and the spacer layer **34.** The third bonding layer **35** is bonded between the spacer layer **34** and the cover layer **36.**

During the assembly process of the image sensor module **3,** the first bonding layer **31** is sandwiched between the image sensor chip **30** and the lens layer **32.** Because the spacer elements **310** simply occupy a small part of the space in the first bonding layer **31,** adjacent spacer elements **310** are squeezed against one another and moving to an equivalent plane with the same potential energy when the first bonding layer **31** pressed by the image sensor chip **30** and the lens layer **32** from two reversed directions, and the glue agent **311** flows to the gap among the spacer elements **310.** Thus, the contact interface of each of the spacer elements **310** with the image sensor chip **30** and lens layer **32** is respective a point-to-point contact, and the glue agent **311** is for joining the image sensor chip **30** and the lens layer **32.** After bonding, the height of the first bonding layer **31** is equal to the thickness of the spacer element **310.** Therefore, when the lens **321** has determined an optical path of where an image projected, the most suitable size of spacer elements **310** can then be selected to determine the thickness of the first bonding layer **31** and to enable the lens layer **32** to accurately focus the projected image onto the image capturing element **300.** In the same manner, the spacer elements **330** or **350** of the second bonding layer **33** or the third bonding layer **35** are used to control the combination thickness between the lens layer **32** and the spacer layer **34** or the combination thickness between the spacer layer **34** and the cover layer **36.** Despite the final thickness of the spacer layer **34** after mechanical engineering, the bonding layers **33** and **35** can use the accurate size of spacer elements **330** and **350** to compensate for manufacturing aberrations. It is unnecessary to accurately control the density of the spacer elements in every bonding layer, only be sure that the respective spacer elements are evenly distributed on an equivalent plane with the same potential energy and dense enough to bear stress from the neighbor top and bottom layers without crash. Experimentally, the mixing density between 1% and 10% shows the same effect. Further, the material for the spacer elements can be selected from SiO₂, SiC, or polystyrene. Micropearl SI-H or glass-fiber developed by Sekisui Chemical Co., Ltd. Japan of different sizes and specifications can be used. In case cylindrical glass-fiber is used for the spacer elements, the circumference of each spacer elements is disposed with contacting the neighbor top and bottom layers as a respective interface of line-to-line contact.

If a relatively greater space between the image sensor chip **30** and the lens layer **32** is necessary, the size of the spacer elements **310** in the first bonding layer **31** may be relatively increased. Alternatively, an additional spacer layer may be sandwiched between two bonding layers to increase the space between the image sensor chip **30** and the lens layer **32,** thereby controlling accurate focusing of the projected image onto the image capturing element **300.** In the aforesaid first embodiment of the present invention, only one lens layer is used in the image sensor module. Alternatively, two or more lens layers may be installed with respective spacer layers sandwiched therebetween.

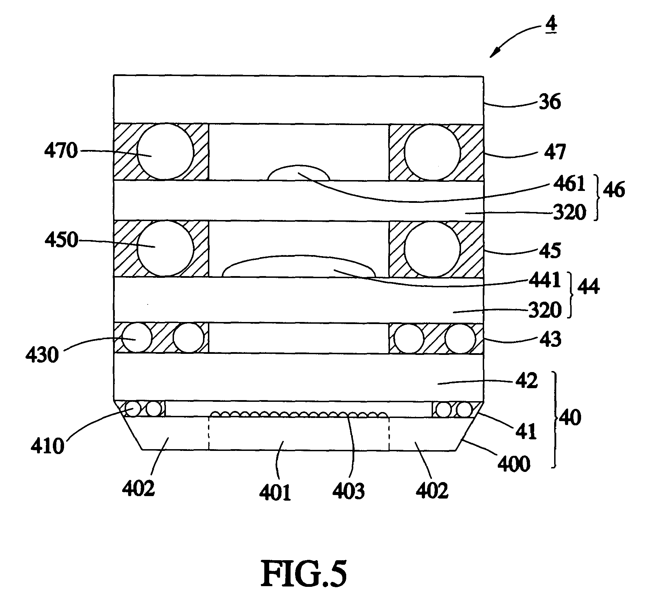

Further, in the aforesaid first embodiment of the present invention, one spacer layer with two bonding layers are used to kept the lens layer and the top cover layer apart. Alternatively one single bonding layer may be used to substitute the arrangement of one spacer layer with two bonding layers. FIG 5 shows an image sensor module **4** in accordance with a second embodiment of the present invention. According to this second embodiment, the image sensor module **4** comprises a chip module **40,** a first lens layer **44** stacked on the chip module **40,** a second lens layer **46** stacked on the first lens layer **44,** a cover layer **36** stacked on the second lens layer **46,** a first bonding layer **43** sandwiched between the chip module **40** and the first lens layer **44,** a second bonding layer **45** sandwiched between the first lens layer **44** and the second lens layer **46,** and a third bonding layer **47** sandwiched between the second lens layer **46** and the cover layer **36.**

The chip module **40** comprises an image sensor chip **400,** a bonding layer **41,** and a transparent panel **42.** The transparent panel **42** is pervious to light, and is bonded to the image sensor chip **400** by the bonding layer **41** to protect the circuit devices of the chip module **40** against environmental pollution. The image sensor chip **400** is manufactured by CIS technology, having an image capturing zone **401** and a partition zone **402.** The image capturing zone **401** is surrounded by the partition zone 402 and having a micro lens array **403** manufactured thereon. The bonding layer **41** is bonded to the top surface of the partition zone **402.** The micro lens array **403** accurately focuses an image projected by the first lens layer **44** and second lens layer **46** on the image capturing zone **401,** projecting the image more effectively on the image sensor chip **400.**

Each of the lens layers **44** and **46** has a transparent substrate **320** disposed with a lens **441** or **461** respectively thereon. The arrangement of the lens layers **44** and **46** optimizes the image sensor module **4** to have wide view angle and high picture quality.

The bonding layers **41, 43, 45** and **47** are arranged corresponding to the partition zone **402** of the image sensor chip **400,** and provided with the respectively necessary thicknesses subject to the respective optical conditions of the lenses **403, 441** and **461.** Same as the material properties of the bonding layer **31** of the aforesaid first embodiment of the present invention, each of the bonding layers **41, 43, 45** and **47** has a respectively predetermined size of spacer elements **410, 430, 450** or **470.** The material and mixing density of the spacer elements **410, 430, 450** or **470** may be prepared in the same manner as the aforesaid first embodiment.

In the image sensor module **4** according to this second embodiment, the spacer elements **410, 430, 450** and **470** are respectively used to control the pitch between the chip module **40** and the transparent panel **42,** the pitch between the transparent panel **42** and the first lens layer **44,** the pitch between the first lens layer **44** and the second lens layer **46,** and the pitch between the second lens layer **46** and the cover layer **36,** thus eliminating the use of the spacer layer **34** in the aforesaid first embodiment or prior art design and saving the manufacturing time in glass material processing as cutting, grinding, etching, and etc. Especially to the multi-layer lenses manufacturing, the bonding layers **41, 43, 45** and **47** effectively enables the lenses **403, 441** and **461** to accurately focus the projected image onto the image sensor chip **400.**

A prototype of image sensor module has been constructed with the features of FIGS. 4 and 5. The image sensor module functions smoothly to provide all of the features discussed earlier.

Although particular embodiments of the invention have been described in detail for purposes of illustration, various modifications and enhancements may be made without departing from the spirit and scope of the invention. Accordingly, the invention is not to be limited except as by the appended claims.

## Claims

1. An image sensor module (3) being **characterized in** comprising
an image sensor chip (30), said image sensor chip (30) having an image capturing zone (301) and a partition zone (302) surrounding said image capturing zone (301);
at least one lens layer (32) stacked on said image sensor chip (30), said lens layer (32) having a transparent substrate (320) and a lens (321) mounted on said transparent substrate (320) and adapted to project the image of an object onto said image capturing zone (301) of said image sensor chip (30); and
at least one bonding layer (31) arranged corresponding to said partition zone (302) of said image sensor chip (30), said bonding layer (31) comprising a glue agent (311) and a plurality of spacer elements (310) mixed in said glue agent (311), the height of said spacer elements (310) being the height of the respective bonding layer (31), said at least one bonding layer (31) bonded between said image sensor chip (30) and said at least one lens layer (32).

2. The image sensor module (3) as claimed in claim 1, wherein said lens layer (32) is deposed of a spacer layer (34) made of a glass material having a predetermined thickness and corresponded to said partition zone (302) of said image sensor chip (30).

3. The image sensor module (3) as claimed in claim 2, wherein said spacer layer (34) is bonded to the transparent substrate (320) of said lens layer (32) with said at least one bonding layer (31).

4. The image sensor module (3) as claimed in claim 2, wherein said at least one bonding layer (31) includes multiple bonding layers (31), said spacer layer (34) is sandwiched between said image sensor chip (30) and said at least one lens layer (32), having two opposite sides respectively bonded to said image sensor chip (30) and to said at least one lens layer (32) by respective said bonding layers (31).

5. The image sensor module (3) as claimed in claim 1, further comprising an optical micro lens array (403) arranged on said image sensor chip (30) and working with said lens layer (32) to focus the projected image of an object onto the image capturing zone (301) of said image sensor chip (30).

6. The image sensor module (3) as claimed in claim 5, further comprising a transparent panel (42) arranged on said micro lens array (403), said at least one bonding layer (31) includes multiple bonding layers (31,33,35), said transparent panel (42) having two opposite sides respectively bonded to said image sensor chip (30) and said at least one lens layer (32) by respective bonding layers (31,33,35).

7. The image sensor module (3) as claimed in claim 1, wherein said at least one bonding layer (31) includes multiple bonding layers (31,33,35), said at least one lens layer (32) includes multiple lens layers (41,43,45,47) stacked on said image sensor chip (30) and bonded to one another by at least one of said bonding layers (31,33,35).

8. The image sensor module (3) as claimed in claim 7, wherein the transparent substrates (320) of each two adjacent lens layers of said multiple lens layers (44,46) are bonded together by one of said bonding layers (31,33,35).

9. The image sensor module (3) as claimed in claim 1, wherein the volume density of mixing the spacer elements (310) and the glue agent (311) of said bonding layer (31) is at the respective ratio of within 1:10~1:100.

10. The image sensor module (3) as claimed in claim 1, wherein the spacer elements (310) of said at least one bonding layer (31) are spherical beads arranged in such a manner that the contact interface of each of said spacer elements (310) with said image sensor chip (30) and said at least one lens layer (32) is respective a point-to-point contact.

11. The image sensor module (3) as claimed in claim 1, wherein the spacer elements (310) of said at least one bonding layer (31) are cylindrical glass-fiber members arranged in such a manner that the contact interface of each of said spacer elements (310) with said image sensor chip (30) and said at least one lens layer (32) is respective a line-to-line contact.

12. The image sensor module (3) as claimed in claim 1, wherein said spacer elements (310) are selected from one of the materials of SiO_{2,} SiC, and polystyrene.

13. The image sensor module (3) as claimed in claim 1, wherein said image sensor chip (30) is manufactured by a SSIS (Solid State Image Sensor) technology of integrated circuit manufacturing.

14. An image sensor module (4) being **characterized in** comprising
an image sensor chip (40), said image sensor chip (40) having an image capturing zone (401) and a partition zone (402) surrounding said image capturing zone (401);
a plurality of lens layers (44,46) stacked on said image sensor chip (40), each of said lens layers (44,46) having a transparent substrate (320) and a lens (441) mounted on said transparent substrate (320) and adapted to project the image of an object onto said image capturing zone (401) of said image sensor chip (40); and
at least one bonding layer (41) arranged corresponding to said partition zone (402) of said image sensor chip (40), said at least one bonding layer (41) comprising a glue agent (311) and a plurality of spacer elements (410) mixed in said glue agent (311), the height of said spacer elements (410) being the height of the respective bonding layer (41), two of said lens layers (44,46) bonded to each other by said at least one bonding layer (41).

15. The image sensor module (4) as claimed in claim 14, wherein said lens layer (44) is deposed of a spacer layer (34) made of a glass material having a predetermined thickness and corresponded to said partition zone (402) of said image sensor chip (40).

16. The image sensor module (4) as claimed in claim 15, wherein one of said spacer layers (34) is bonded to the respective transparent substrate (320) of said lens layer (44) with said at least one bonding layer (41).

17. The image sensor module (4) as claimed in claim 15, wherein said at least one bonding layer (41) includes multiple bonding layers (41,43,45,47), one of said spacer layers (34) is sandwiched between said image sensor chip (40) and the respective lens layer (44,46), having two opposite sides respectively bonded to said image sensor chip (40) and to said lens layer (44) by respective said bonding layers (41,43,45,47).

18. The image sensor module (4) as claimed in claim 14, further comprising an optical micro lens array (403) arranged on said image sensor chip (40) and working with said lens layers (44,46) to focus the projected image of an object onto the image capturing zone (402) of said image sensor chip (40).

19. The image sensor module (4) as claimed in claim 18, further comprising a transparent panel (42) arranged on said micro lens array (403), said at least one bonding layer (41) includes multiple bonding layers (41,43,45,47), said transparent panel (42) having two opposite sides respectively bonded to said image sensor chip (40) and to one of said lens layers (44,46) by respective bonding layers (41,43,45,47).

20. The image sensor module (4) as claimed in claim 14, wherein said at least one bonding layer (41) includes multiple bonding layers (41,43,45,47), said image sensor chip (40) bonded with one of said lens layers (44,46) by at least one of said bonding layers (41,43,45,47).

21. The image sensor module (4) as claimed in claim 20, wherein the transparent substrates (320) of each two adjacent lens layers of said lens layers (44,46) are bonded together by one of said bonding layers (41).

22. The image sensor module (4) as claimed in claim 14, wherein the volume density of mixing the spacer elements (310) and the glue agent (311) of said bonding layer (41) is at the respective ratio of within 1:10~1:100.

23. The image sensor module (4) as claimed in claim 14, wherein the spacer elements (310) of said at least one bonding layer (41) are spherical beads arranged in such a manner that the contact interface of each of said spacer elements (310) with said lens layer (44) is respective a point-to-point contact.

24. The image sensor module (4) as claimed in claim 14, wherein the spacer elements (310) of said at least one bonding layer (41) are cylindrical glass-fiber members arranged in such a manner that the contact interface of each of said spacer elements (310) with said lens layer (44) is respective a line-to-line contact.

25. The image sensor module (4) as claimed in claim 14, wherein said spacer elements (310) are selected from one of the materials of SiO₂, SiC, and polystyrene.

26. The image sensor module (4) as claimed in claim 14, wherein said image sensor chip (40) is manufactured by a SSIS (Solid State Image Sensor) technology of integrated circuit manufacturing.
